# EUROPÄISCHE PATENTANMELDUNG

(11) **EP 2 933 223 A2**
(43) Veröffentlichungstag der Anmeldung: **21.10.2015**
(21) Anmeldenummer: 15162971.4
(22) Anmeldetag: 09.04.2015
(51) Int. Cl.: B81B 7/00, H01L 23/26

(54) **VERFAHREN UND VORRICHTUNG ZUM EINSTELLEN EINES DRUCKS IN EINER KAVITÄT EINER MIKROFLUIDISCHEN VORRICHTUNG**

(30) Priorität: 17.04.2014 DE 102014207466
(71) Anmelder: Robert Bosch GmbH, 70442 Stuttgart (DE)
(72) Erfinder: Daub, Martina, 71287 Weissach (DE); Brettschneider, Thomas, 71229 Leonberg (DE); Laermer, Franz, 71263 Weil Der Stadt (DE)

(57) **Zusammenfassung**

Die Erfindung betrifft ein Verfahren (100) zum Einstellen eines Druckes in einer mikrofluidischen Vorrichtung. Das Verfahren (100) weist einen Schritt (110) des Bereitstellens eines Schichtstapels aus einem ersten Substrat und einem zweiten Substrat auf. Hierbei ist zwischen dem ersten Substrat und dem zweiten Substrat zumindest eine Kavität angeordnet, in der zumindest ein Druckeinstellmaterialkörper angeordnet ist. Dabei ist zumindest das erste Substrat für Lichtenergie in einem Wellenlängenbereich transparent ausgeführt. Auch weist das Verfahren (100) einen Schritt (120) des Einkoppelns von Lichtenergie in dem Wellenlängenbereich durch das erste Substrat hindurch in den zumindest einen Druckeinstellmaterialkörper innerhalb der zumindest einen Kavität auf, um ein Druckeinstellmaterial des zumindest einen Druckeinstellmaterialkörpers zu aktivieren, um einen Druck in der zumindest einen Kavität unter Verwendung des Druckeinstellmaterials physikochemisch einzustellen.

## Beschreibung

### Stand der Technik

Die vorliegende Erfindung bezieht sich auf ein Verfahren zum Einstellen eines Druckes in einer mikrofluidischen Vorrichtung, auf eine entsprechende Vorrichtung sowie auf ein entsprechendes Computerprogrammprodukt oder Computerprogramm und auf eine mikrofluidische Vorrichtung.

Mikrofluidische Lab-on-a-Chip-Systeme können insbesondere Mehrschichtaufbauten mit integrierten mikrofluidischen Kanälen und Kavitäten aufweisen. Solche Lab-on-a-Chip-Systeme können beispielsweise druckgetrieben sein, wobei zum Beispiel Flüssigkeiten in mikrofluidischen Kanälen und Kammern transportiert und/oder beispielsweise Membranventile geschaltet werden können.

### Offenbarung der Erfindung

Vor diesem Hintergrund werden mit dem hier vorgestellten Ansatz ein Verfahren zum Einstellen eines Druckes in einer mikrofluidischen Vorrichtung, eine entsprechende Vorrichtung sowie ein entsprechendes Computerprogrammprodukt oder Computerprogramm und eine mikrofluidische Vorrichtung gemäß den Hauptansprüchen vorgestellt. Vorteilhafte Ausgestaltungen ergeben sich aus den jeweiligen Unteransprüchen und der nachfolgenden Beschreibung.

Gemäß Ausführungsformen der Erfindung können insbesondere definierte Druckverhältnisse in Mikrokavitäten einer mikrofluidischen Vorrichtung eingestellt bzw. unterschiedliche Druckzustände, d. h. Überdruck oder Unterdruck, innerhalb einer Kavität eines Schichtsystems einer mikrofluidischen Vorrichtung bereitgestellt, sowie gegebenenfalls eine bestimmte Gaszusammensetzung darin eingestellt werden. Insbesondere kann durch Einwirkung von Lichtenergie auf einen in der Kavität angeordneten Druckeinstellmaterialkörper die Stoffmenge einer Gasphase in der zumindest einen Kavität beeinflusst werden.

Vorteilhafterweise kann gemäß Ausführungsformen der Erfindung ermöglicht werden, beispielsweise konventionelle diagnostische Assays zu integrieren und automatisiert ablaufen zu lassen, wodurch sich Zeit- und Kostenvorteile ergeben. So können beispielsweise für ein druckgetriebenes Lab-on-a-Chip-System Druckverhältnisse, z. B. Überdruck oder Unterdruck, bereitgestellt werden, welche dafür genutzt werden können, Flüssigkeiten in mikrofluidischen Kanälen und Kammern zu transportieren oder beispielsweise Membranventile zu schalten. Es kann insbesondere im Fertigungsprozess innerhalb einer geschlossenen Kavität ein bestimmter Druckzustand eingeprägt werden.

Insbesondere kann vorteilhafterweise ein Aufwand umgangen werden, über eine Schnittstelle des Systems zur Außenwelt bzw. über einen Zugang ein Gas mit Überdruck in die Kavität zu pumpen, diesen Zugang anschließend dauerhaft zu verschließen, sowie analog hinsichtlich eines Unterdrucks vorzugehen, und so ein Gas für eine spätere Verwendung bereitzustellen. Somit sind zum Bereitstellen eines Druckzustandes in einem Bauteil bzw. einer Kavität während der Herstellung kein Zugang zur Kavität bzw. keine Schnittstelle zur Kavität und kein Druckgenerator nötig. Gemäß Ausführungsformen der Erfindung kann auf einen zusätzlichen Zugang und auf einen Druckgenerator verzichtet werden. Zusätzlich kann ein Prozessschritt entfallen, bei welchem ein Zugang nach Einprägen des Druckzustandes dauerhaft zu verschließen ist. Hierdurch kann eine Prozesssicherheit erhöht und können Kosten gesenkt werden.

Auch kann vorteilhafterweise vermieden werden, dass beispielsweise im Betrieb verschiedene Druckzustände durch die Zufuhr bzw. Entzug von Wärme bereitzustellen sind. So braucht die Vorrichtung beispielsweise nicht im Rahmen einer thermopneumatischen Betätigung bzw. Aktuierung von außen geheizt oder gekühlt zu werden und es brauchen keine integrierten Heizelemente verwendet zu werden. Somit kann eine bei thermopneumatischen Aktuierungskonzepten bzw. Betätigungskonzepten aufgrund beschränkter verwendbarer Temperaturen gegebene Beschränkung erreichbarer Über- und Unterdrücke verhindert werden. Gemäß Ausführungsformen der Erfindung kann eine Höhe eines Druckes in einer Kavität in einem großen Wertebereich eingestellt werden, da direkt auf eine Teilchenzahl Einfluss genommen wird.

Es wird ein Verfahren zum Einstellen eines Druckes in einer mikrofluidischen Vorrichtung vorgestellt, wobei das Verfahren folgende Schritte aufweist:
Bereitstellen eines Schichtstapels, der ein erstes Substrat und ein zweites Substrat aufweist, wobei zwischen dem ersten Substrat und dem zweiten Substrat zumindest eine Kavität angeordnet ist, in der zumindest ein Druckeinstellmaterialkörper angeordnet ist, wobei zumindest das erste Substrat für Lichtenergie eines Wellenlängenbereichs transparent ausgeformt ist; und

Einkoppeln von Lichtenergie des Wellenlängenbereichs durch das erste Substrat hindurch in den zumindest einen Druckeinstellmaterialkörper innerhalb der zumindest einen Kavität, um ein Druckeinstellmaterial des zumindest einen Druckeinstellmaterialkörpers zu aktivieren, um einen Druck in der zumindest einen Kavität unter Verwendung des Druckeinstellmaterials physikochemisch einzustellen.

Die mikrofluidische Vorrichtung kann als ein mikrofluidisches System oder als ein Teil eines mikrofluidischen Systems ausgeführt sein, wobei es sich bei dem mikrofluidischen System bzw. der mikrofluidischen Vorrichtung um ein System zu Analysezwecken handeln kann, insbesondere ein in-vitro-Diagnostiksystem, mikrofluidisches Lab-on-Chip-System bzw. Chiplabor-System zur medizinischen Diagnostik bzw. Analytik, mikrobiologischen Diagnostik oder Umweltanalytik. Die Lichtenergie kann mittels zumindest eines Laserstrahls eingekoppelt werden. Der Schichtstapel kann zumindest ein weiteres Substrat aufweisen. Der Schichtstapel kann zwischen der Kavität und einer Außenfläche des Schichtstapels, von der aus die Lichtenergie eingekoppelt wird, zumindest ein für Lichtenergie in dem Wellenlängenbereich transparent oder teiltransparent ausgeführtes Substrat aufweisen. Die zumindest eine Kavität kann einen Hohlraum, einen Kanal, eine Kammer und/oder dergleichen aufweisen. Der zumindest eine Druckeinstellmaterialkörper kann Druckeinstellmaterial in kompakter flüssiger oder fester Form, beispielsweise als Partikel, Korn, Plättchen oder dergleichen, oder amorpher oder pastöser Form aufweisen. Ein Druckeinstellmaterialkörper kann hierbei auch als Target bzw. Mikrotarget bezeichnet werden. Der Druckeinstellmaterialkörper kann in flüssiger oder fester Form auf das Substrat aufgebracht sein, z. B. als ein Tropfen, der auf einer Substratoberfläche verlaufen und erhärten kann. Der Druckeinstellmaterialkörper braucht also kein loser, fester Körper zu sein. Der Druckeinstellmaterialkörper kann beispielsweise als ein freier Materialkörper in fester Form oder als Pulver oder als Film, welcher beispielsweise als Flüssigkeitstropfen aufgebracht ist, ausgeführt sein. Der Druckeinstellmaterialkörper kann insbesondere in einem festen oder flüssigen Aggregatszustand vorliegen. Ferner kann das Verfahren einen Schritt des Anordnens des zumindest einen Druckeinstellmaterialkörpers in der zumindest einen Kavität aufweisen. Im Schritt des Einkoppelns kann beispielsweise mittels gepulster Laserstrahlung das Druckeinstellmaterial erwärmt und/oder durch Laserablation verdampft werden. Im Schritt des Einkoppelns kann ein Einsatz eines Lasers zur Materialbearbeitung, insbesondere Laser-Ablation bzw. Pulsed Laser Deposition, vorgesehen sein, wobei das Druckeinstellmaterial durch eine Wechselwirkung mit Licht erwärmt und/oder verdampft werden kann. Unter einem physikochemischen Einstellen kann eine chemische Umwandlung zumindest eines Teils des Druckeinstellmaterials (beispielsweise in eine Gasphase oder unter Verwendung von Komponenten aus dem die Kavität füllenden Gas in eine feste Phase) verstanden werden, sodass der Druck in der Kavität gezielt verändert wird. Bei dem physikochemischen Einstellen des Drucks kann somit im Schritt des Einkoppelns eine Stoffmenge einer Gasphase in der zumindest einen Kavität beeinflusst werden, insbesondere durch zumindest eine Materialeigenschaft des Druckeinstellmaterials, wie beispielsweise eine Masse, eine Art von Substanz etc., und zusätzlich oder alternativ durch zumindest eine Einkopplungseigenschaft, wie beispielsweise eine Einkopplungsdauer, eine Einkopplungsleistung etc.

Gemäß einer Ausführungsform kann im Schritt des Bereitstellens ein Schichtstapel bereitgestellt werden, dessen zumindest einer Druckeinstellmaterialkörper ein Gasfreisetzungsmaterial aufweist. Hierbei kann im Schritt des Einkoppelns mittels der Lichtenergie des Wellenlängenbereichs das Gasfreisetzungsmaterial zum Freisetzen von Gasmolekülen verdampfbar sein und/oder verdampft werden. Durch Verdampfen des Gasfreisetzungsmaterials kann eine Stoffmenge einer Gasphase in der zumindest einen Kavität erhöht und zusätzlich oder alternativ eine Gaszusammensetzung in der zumindest einen Kavität beeinflusst werden. Eine solche Ausführungsform bietet den Vorteil, dass ein Überdruck und zusätzlich oder alternativ eine Gaszusammensetzung in der zumindest einen Kavität zuverlässig und genau einstellbar ist.

Auch kann im Schritt des Bereitstellens ein Schichtstapel bereitgestellt werden, dessen zumindest einer Druckeinstellmaterialkörper ein Gettermaterial aufweist. Hierbei kann im Schritt des Einkoppelns mittels der Lichtenergie des Wellenlängenbereichs das Gettermaterial zum Einfangen und/oder Absorbieren von Gasmolekülen aktivierbar sein und/oder aktiviert werden. Durch Aktivieren des Gettermaterials kann eine Stoffmenge einer Gasphase in der zumindest einen Kavität gesenkt werden. Das Gettermaterial kann im Schritt des Einkoppelns erwärmt und/oder verdampft werden, um das Gettermaterial zu aktivieren. Das Gettermaterial, das auch als ein thermisch aktivierbarer Getter bezeichnet werden kann, kann ausgebildet sein, um Gasatome oder Gasmoleküle an seiner Oberfläche zu adsorbieren oder mit denselben zu reagieren. Ein Gettermaterial kann ausgebildet sein, um insbesondere ein dauerhaftes Vakuum innerhalb der zumindest einen Kavität aufrecht zu erhalten. Gettermaterialien können beispielsweise durch thermische Einwirkung aktiviert werden, bevor sie ihre Funktion erfüllen. Die thermische Einwirkung kann dabei durch Einkoppeln der Lichtenergie des Wellenlängenbereichs erfolgen. Insbesondere in Kombination mit einem polymeren Schichtaufbau der Substrate des Schichtstapels kann hierbei eine notwendige Temperaturerhöhung lokal auf das Gettermaterial beschränkt werden, um die Substrate zu schonen. Eine solche Ausführungsform bietet den Vorteil, dass auch ein Unterdruck in der zumindest einen Kavität zuverlässig erzeugt und gehalten werden kann sowie gegebenenfalls unerwünschte Gasatome bzw. Gasmoleküle bzw. Restgase entfernt werden können.

Ferner kann im Schritt des Bereitstellens ein Schichtstapel bereitgestellt werden, in dessen zumindest einer Kavität ein erster Druckeinstellmaterialkörper mit einem Gettermaterial und ein zweiter Druckeinstellmaterialkörper mit einem Gasfreisetzungsmaterial angeordnet sind. Hierbei kann im Schritt des Einkoppelns in einem ersten Teilschritt die Lichtenergie des Wellenlängenbereichs in den ersten Druckeinstellmaterialkörper eingekoppelt werden, um das Gettermaterial zu aktivieren, und kann in einem zweiten Teilschritt die Lichtenergie des Wellenlängenbereichs in den zweiten Druckeinstellmaterialkörper eingekoppelt werden, um das Gasfreisetzungsmaterial zu verdampfen. Der erste Druckeinstellmaterialkörper und der zweite Druckeinstellmaterialkörper können in derselben Kavität angeordnet sein. Auch kann im Schritt des Bereitstellens ein Schichtstapel bereitgestellt werden, eine erste Kavität und eine mit der ersten Kavität fluidisch verbundene, zweite Kavität aufweist, wobei der erste Druckeinstellmaterialkörper in der ersten Kavität angeordnet ist und der zweite Druckeinstellmaterialkörper in der zweiten Kavität angeordnet ist. Eine solche Ausführungsform bietet den Vorteil, dass auf diese Weise eine besonders genaue Einstellung des Drucks und der Gaszusammensetzung erfolgen kann, da keine oder nur geringe Restgase vorhanden sind.

Gemäß einer Ausführungsform kann im Schritt des Bereitstellens der Schichtstapel in einem gefügten Zustand bereitgestellt werden, in dem das erste Substrat und das zweite Substrat stoffschlüssig miteinander verbunden sind. Eine solche Ausführungsform bietet den Vorteil, dass somit aufgrund der beim Einkoppeln erfolgenden Durchstrahlung des ersten Substrats auch in einem bereits gefügten Schichtstapel ein Druck und/oder eine Gaszusammensetzung in zumindest einer innenliegenden Kavität eingestellt werden kann. So kann die Herstellung der mikrofluidischen Vorrichtung vergünstigt und vereinfacht werden.

Alternativ kann im Schritt des Bereitstellens der Schichtstapel in einem ungefügten Zustand bereitgestellt werden, in dem das erste Substrat und das zweite Substrat ungefügt aufeinander gestapelt sind. Hierbei kann das zweite Substrat für die Lichtenergie in dem Wellenlängenbereich absorbierend ausgeführt sein. Dabei kann im Schritt des Einkoppelns die Lichtenergie in den Schichtstapel eingekoppelt werden, um das erste Substrat und das zweite Substrat stoffschlüssig miteinander zu verbinden. Eine solche Ausführungsform bietet den Vorteil, dass, in Kombination mit einem Laserschweißverfahren, sowohl das Einstellen von Druck und/oder Gaszusammensetzung als auch das Fügen des Schichtstapels in einem Prozessschritt erfolgen können, wodurch der gesamte Aufbauprozess verkürzt und vereinfacht werden kann. So können Kosten gesenkt werden, insbesondere wenn während eines Herstellungsprozesses ohnehin ein Laser zum Fügen der Substrate bzw. Schichten eingesetzt wird, beispielsweise mittels Laserdurchstrahlschweißens.

Anders ausgedrückt kann ferner insbesondere ein Verfahren zum Herstellen bzw. auch zum Betreiben einer mikrofluidischen Vorrichtung bereitgestellt werden, wobei zwei Substrate bereitgestellt werden können, wobei zwischen dem ersten und zweiten Substrat eine Kavität angeordnet ist, in der ein Materialkörper bzw. Druckeinstellmaterialkörper angeordnet ist. Außerdem kann mindestens eines der beiden Substrate für Licht eines Wellenlängenbereichs transparent ausgeführt sein. Insbesondere kann entweder während der Herstellung oder im späteren Betrieb der mikrofluidischen Vorrichtung durch Einwirkung von Lichtenergie auf den in der Kavität angeordneten Druckeinstellmaterialkörper eine Freisetzung von Gasen bewirkt werden, wodurch ein Überdruck innerhalb der Kavität bereitgestellt werden kann. Auch kann beispielsweise durch Verwendung eines Gettermaterials als Druckeinstellmaterialkörper, welcher mittels Lichtenergie aktivierbar ist, entsprechend ein Unterdruck bereitgestellt werden.

Auch wird eine mikrofluidische Vorrichtung vorgestellt, die einen Schichtstapel aufweist, der ein erstes Substrat und ein zweites Substrat aufweist, wobei zwischen dem ersten Substrat und dem zweiten Substrat zumindest eine Kavität angeordnet ist, dadurch gekennzeichnet, dass in der zumindest einen Kavität zumindest ein Druckeinstellmaterialkörper angeordnet ist, wobei zumindest das erste Substrat für Lichtenergie eines Wellenlängenbereichs transparent ausgeformt ist, sodass Lichtenergie des Wellenlängenbereichs durch das erste Substrat hindurch in den zumindest einen Druckeinstellmaterialkörper innerhalb der zumindest einen Kavität einkoppelbar ist, um ein Druckeinstellmaterial des zumindest einen Druckeinstellmaterialkörpers zu aktivieren, um einen Druck in der zumindest einen Kavität unter Verwendung des Druckeinstellmaterials physikochemisch einzustellen.

Der Druck in der mikrofluidischen Vorrichtung kann durch Ausführen einer Ausführungsform des vorstehend genannten Verfahrens vorteilhaft eingestellt werden. Die Vorrichtung kann dabei eine Kavität ohne dedizierte Einbringöffnung zum Einbringen des zumindest einen Druckeinstellmaterialkörpers aufweisen.

Der hier vorgestellte Ansatz schafft ferner eine Vorrichtung, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt auf einem Computer oder einer Vorrichtung ausgeführt wird.

Der hier vorgestellte Ansatz wird nachstehend anhand der beigefügten Zeichnungen beispielhaft näher erläutert. Es zeigen:
Fig. 1 ein Ablaufdiagramm eines Verfahrens zum Herstellen einer mikrofluidischen Vorrichtung gemäß einem Ausführungsbeispiel der vorliegenden Erfindung; und
Figuren 2 bis 4 schematische Schnittdarstellungen von mikrofluidischen Vorrichtungen gemäß Ausführungsbeispielen der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

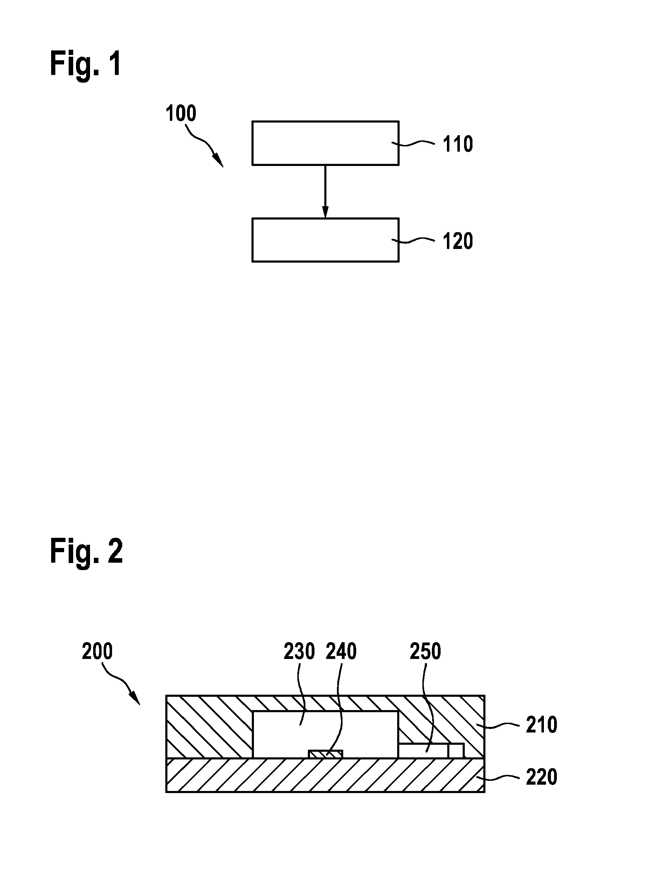

Fig. 1 zeigt ein Ablaufdiagramm eines Verfahrens 100 zum Einstellen eines Druckes in einer mikrofluidischen Vorrichtung gemäß einem Ausführungsbeispiel der vorliegenden Erfindung. Durch Ausführen des Verfahrens 100 ist ein Druck in einer mikrofluidischen Vorrichtung, wie einer der mikrofluidischen Vorrichtungen aus einer der Figuren 2 bis 4, vorteilhaft einstellbar.

Das Verfahren 100 weist einen Schritt 110 des Bereitstellens eines Schichtstapels auf, der ein erstes Substrat und ein zweites Substrat aufweist. Dabei ist zwischen dem ersten und dem zweiten Substrat zumindest eine Kavität angeordnet, in der zumindest ein Druckeinstellmaterialkörper angeordnet ist. Hierbei ist zumindest das erste Substrat für Lichtenergie in einem Wellenlängenbereich transparent ausgeformt.

Auch wenn es in Fig. 1 nicht gezeigt ist, kann das Verfahren 100 optional einen Schritt des Anordnens des zumindest einen Druckeinstellmaterialkörpers in der zumindest einen Kavität des Schichtstapels aufweisen. Dabei kann der Schritt des Anordnens vor dem Schritt 110 des Bereitstellens oder als ein Teilschritt des Schrittes 110 des Bereitstellens ausgeführt werden. Im Schritt des Anordnens kann eine Menge an Druckeinstellmaterial und/oder eine Art des angeordneten Druckeinstellmaterials gewählt werden.

Gemäß einem Ausführungsbeispiel wird im Schritt 110 des Bereitstellens der Schichtstapel in einem gefügten Zustand bereitgestellt, in dem das erste Substrat und das zweite Substrat stoffschlüssig miteinander verbunden sind. Dabei kann der optionale Schritt des Anordnens vor dem Fügen des Schichtstapels ausgeführt werden.

Gemäß einem Ausführungsbeispiel wird im Schritt 110 des Bereitstellens der Schichtstapel in einem ungefügten Zustand bereitgestellt, in dem das erste Substrat und das zweite Substrat ungefügt aufeinander gestapelt sind. Hierbei ist das zweite Substrat für die Lichtenergie in dem Wellenlängenbereich absorbierend ausgeführt. So wird gemäß diesem Ausführungsbeispiel im Schritt 120 des Einkoppelns die Lichtenergie in den Schichtstapel eingekoppelt, um sowohl Druckeinstellmaterial zu aktivieren als auch das erste und das zweite Substrat stoffschlüssig miteinander zu verbinden.

Ferner weist das Verfahren 100 einen Schritt 120 des Einkoppelns von Lichtenergie in dem Wellenlängenbereich durch das erste Substrat hindurch in den zumindest einen Druckeinstellmaterialkörper innerhalb der zumindest einen Kavität auf, um ein Druckeinstellmaterial des zumindest einen Druckeinstellmaterialkörpers zu aktivieren, um einen Druck in der zumindest einen Kavität unter Verwendung des Druckeinstellmaterials physikochemisch einzustellen. Die Lichtenergie wird insbesondere mittels Laser eingekoppelt.

Im Schritt 120 des Einkoppelns wird somit insbesondere zumindest ein Laserstrahl verwendet, wobei Lasereigenschaften bzw. Laserparameter beispielsweise eine Wellenlänge von 200 Nanometer bis 10 Mikrometer, insbesondere von 255 bis 1064 Nanometer, eine Pulsdauer von 500 Nanosekunden bis 100 Femtosekunden, insbesondere 100 Nanosekunden bis 10 Pikosekunden, und eine Laserleistung von 100 Milliwatt bis 100 Watt umfassen. Beispielsweise wird dabei im Schritt 120 des Einkoppelns die Lichtenergie mit einem großen Strahlöffnungswinkel unter Verwendung einer optischen Einrichtung mit hoher numerischer Apertur und zusätzlich oder alternativ in mehreren Strahlen unter Verwendung mehrerer optischer Einrichtungen oder einer optischen Einrichtung mit einem Strahlteiler eingekoppelt.

In einer ersten Ausführungsvariante des Verfahrens 100 wird im Schritt 110 des Bereitstellens ein Schichtstapel bereitgestellt, dessen zumindest einer Druckeinstellmaterialkörper ein Gasfreisetzungsmaterial aufweist. Hierbei wird im Schritt 120 des Einkoppelns mittels der Lichtenergie des Wellenlängenbereichs das Gasfreisetzungsmaterial zum Freisetzen von Gasmolekülen verdampft.

In einer zweiten Ausführungsvariante des Verfahrens 100 wird im Schritt 110 des Bereitstellens ein Schichtstapel bereitgestellt, dessen zumindest einer Druckeinstellmaterialkörper ein Gettermaterial aufweist. Dabei wird im Schritt 120 des Einkoppelns mittels der Lichtenergie des Wellenlängenbereichs das Gettermaterial zum Einfangen von Gasmolekülen aktiviert.

In einer dritten Ausführungsvariante des Verfahrens 100 wird im Schritt 110 des Bereitstellens ein Schichtstapel bereitgestellt, in dessen zumindest einer Kavität ein erster Druckeinstellmaterialkörper mit einem Gettermaterial und ein zweiter Druckeinstellmaterialkörper mit einem Gasfreisetzungsmaterial angeordnet sind. Hierbei wird im Schritt 120 des Einkoppelns in einem ersten Teilschritt die Lichtenergie des Wellenlängenbereichs in den ersten Druckeinstellmaterialkörper eingekoppelt, um das Gettermaterial zu aktivieren, und wird in einem zweiten Teilschritt die Lichtenergie des Wellenlängenbereichs in den zweiten Druckeinstellmaterialkörper eingekoppelt, um das Gasfreisetzungsmaterial zu verdampfen.

Fig. 2 zeigt eine schematische Schnittdarstellung einer mikrofluidischen Vorrichtung 200 gemäß einem Ausführungsbeispiel der vorliegenden Erfindung. Hierbei ist ein Druck in der mikrofluidischen Vorrichtung 200 durch Ausführen des Verfahrens aus Fig. 1 eingestellt oder einstellbar. Anders ausgedrückt ist die mikrofluidische Vorrichtung 200 in einem Zustand gezeigt, der beim Ausführen des Verfahrens aus Fig. 1 durchlaufen wird bzw. mit dem Verfahren aus Fig. 1 in Zusammenhang steht. Die mikrofluidische Vorrichtung 200 ist dabei in einem Zustand gezeigt, der nach dem Schritt des Bereitstellens und dem Schritt des Anordnens sowie vor oder nach dem Schritt des Einkoppelns des Verfahrens aus Fig. 1 erreicht ist. Gezeigt sind in Fig. 2 von der mikrofluidischen Vorrichtung 200 hierbei ein erstes Substrat 210, ein zweites Substrat 220, eine Kavität 230, ein Druckeinstellmaterialkörper 240, der ein Druckeinstellmaterial aufweist, und ein mikrofluidischer Kanal 250.

Das erste Substrat 210 und das zweite Substrat 220 repräsentieren einen Schichtstapel bzw. Schichtaufbau der mikrofluidischen Vorrichtung 200. Dabei sind das erste Substrat 210 und das zweite Substrat 220 aufeinander gestapelt angeordnet. Das erste Substrat 210 ist beispielsweise für Lichtwellenlängen in dem in Fig. 1 im Zusammenhang mit dem Schritt des Einkoppelns erwähnten Wellenlängenbereich transparent ausgeführt. Gemäß dem in Fig. 2 dargestellten Ausführungsbeispiel der vorliegenden Erfindung ist das zweite Substrat 220 beispielsweise für Lichtwellenlängen in dem erwähnten Wellenlängenbereich absorbierend ausgeführt. Gemäß einem anderen Ausführungsbeispiel kann das zweite Substrat 220 auch für Lichtwellenlängen in dem erwähnten Wellenlängenbereich transparent ausgeführt sein.

Das erste Substrat 210 weist einen Vertiefungsabschnitt auf, der in einer dem zweiten Substrat 220 zugewandten Oberfläche des ersten Substrats 210 ausgeformt ist. Außerhalb des Vertiefungsabschnittes sind das erste Substrat 210 und das zweite Substrat 220 aneinander anliegend angeordnet. Somit ist eine dem zweiten Substrat 220 zugewandte Oberfläche des ersten Substrats 210 außer in dem Vertiefungsabschnitt in Anlage gegen eine dem ersten Substrat 210 zugewandte Oberfläche des zweiten Substrats 220 angeordnet. In einem gestapelten Zustand des ersten Substrats 210 und des zweiten Substrats 220 ist die Kavität 230 durch den Vertiefungsabschnitt und einen Teilabschnitt der dem ersten Substrat 210 zugewandten Oberfläche des zweiten Substrats 220 ausgebildet.

Der Druckeinstellmaterialkörper 240 ist in der Kavität 230 angeordnet. Dabei ist der Druckeinstellmaterialkörper 240 an der dem ersten Substrat 210 zugewandten Oberfläche des zweiten Substrats 220 im Bereich der Kavität 230 angeordnet. Das Druckeinstellmaterial des Druckeinstellmaterialkörpers 240 weist hierbei ein Gasfreisetzungsmaterial, das mittels Lichtenergie des Wellenlängenbereichs, für den das erste Substrat 210 transparent ist, zum Freisetzen von Gasmolekülen verdampfbar ist, oder ein Gettermaterial auf, das mittels Lichtenergie des Wellenlängenbereichs, für den das erste Substrat 210 transparent ist, zum Einfangen von Gasmolekülen aktivierbar ist.

Der mikrofluidische Kanal 250 ist gemäß dem in Fig. 2 dargestellten Ausführungsbeispiel der vorliegenden Erfindung im ersten Substrat 210 ausgeformt. Dabei mündet der mikrofluidische Kanal 250 in die Kavität 230. Anders ausgedrückt ist gemäß dem in Fig. 5 dargestellten Ausführungsbeispiel der vorliegenden Erfindung die Kavität 230 über den mikrofluidische Kanal 250 in ein fluidisches Netzwerk integrierbar.

Anders ausgedrückt zeigt Fig. 2 eine Schnittansicht der mikrofluidischen Vorrichtung 200 nach Bereitstellen des ersten Substrats 210 und des zweiten Substrats 220, wobei innerhalb des ersten Substrats 210 die Kavität 230 angeordnet ist. Innerhalb der Kavität 230 ist der Druckeinstellmaterialkörper 240 angeordnet. Die Kavität 230 ist über den mikrofluidischen Kanal 250 mit einem mikrofluidischen Netzwerk verbunden. Dabei kann in dem mikrofluidischen Kanal 250 ein normal-geschlossenes Ventil angeordnet sein, also ein Ventil, welches ohne zusätzliche Aktuierung abdichtet und im Betrieb bei Bedarf geöffnet werden kann.

Materialbeispiele umfassen für das erste Substrat 210 und das zweite Substrat 220 hierbei Glas, Silizium, Thermoplaste, z. B. PC, PP, PE, PMMA, COP, COC, oder dergleichen, und für den Druckeinstellmaterialkörper 240 Gasfreisetzungsmaterialien bzw. Materialien zur Erzeugung von Gas, wie beispielsweise organische Verbindungen, Kohlenwasserstoffe, Polymere und dergleichen, bzw. Gettermaterialien, beispielsweise wie Barium, Aluminium, Magnesium, Calcium, Natrium, Strontium, Phosphor, entsprechende Legierungen, sowie Legierungen St 707, St 787, St 101, und dergleichen. Das erste Substrat 210 und das zweite Substrat 220 weisen beispielhaft eine Dicke von 0,1 bis 10 Millimeter auf. Ein Volumen der Kavität 230 beträgt beispielsweise 10 Mikroliter bis 10 Milliliter. Im Falle einer Überdruckerzeugung durch Verdampfen eines Gasfreisetzungsmaterials betragen typische Zieldrücke beispielsweise 1000 Millibar bis 5000 Millibar, insbesondere 1500 Millibar bis 2500 Millibar, wobei eine Materialmenge an Gasfreisetzungsmaterial beispielsweise 0,01 Milligramm bis 50 Milligramm beträgt. Im Falle einer Unterdruckerzeugung durch Aktivieren von Gettermaterialien betragen typische Zieldrücke beispielsweise 0 Millibar bis 1000 Millibar, insbesondere 10 Millibar bis 200 Millibar, wobei eine Gettermaterialmenge beispielsweise 0,01 Milligramm bis 50 Milligramm beträgt.

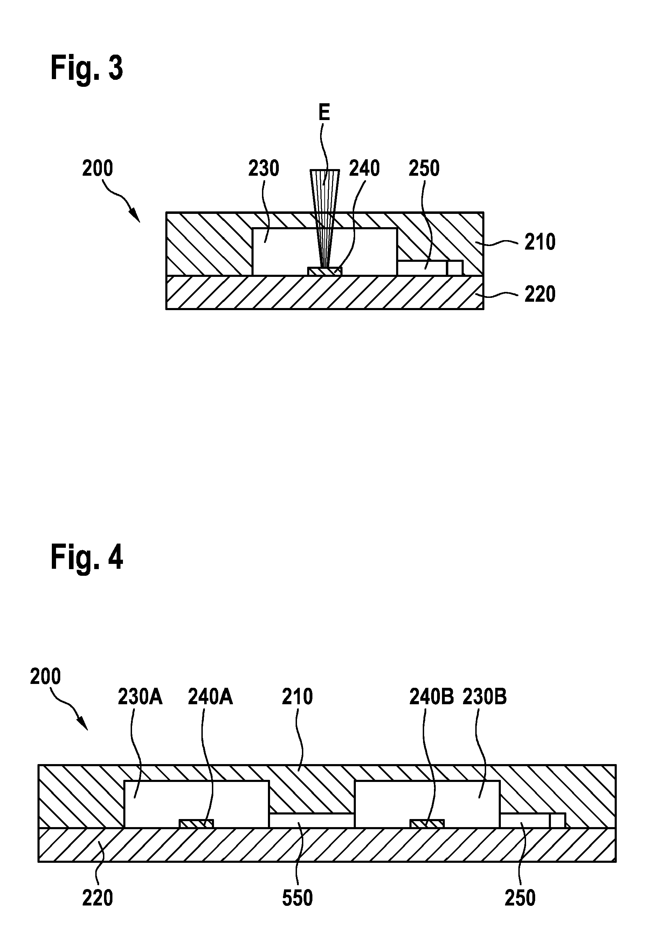

Fig. 3 zeigt eine schematische Schnittdarstellung der mikrofluidischen Vorrichtung 200 aus Fig. 2. Hierbei ist die mikrofluidische Vorrichtung 200 in Fig. 3 in einem bezüglich des in Fig. 2 gezeigten Zustandes unterschiedlichen, weiteren Zustand gezeigt, der beim Ausführen des Verfahrens aus Fig. 1 durchlaufen wird bzw. mit dem Verfahren aus Fig. 1 in Zusammenhang steht. Die mikrofluidische Vorrichtung 200 ist dabei in einem Zustand gezeigt, der bei dem Schritt des Einkoppelns des Verfahrens aus Fig. 1 erreicht ist. Dabei entsprechen die mikrofluidische Vorrichtung 200 sowie die Darstellung in Fig. 3 der mikrofluidischen Vorrichtung sowie der Darstellung aus Fig. 2 mit der Ausnahme, dass in Fig. 3 zusätzlich Lichtenergie in Gestalt eines in die mikrofluidische Vorrichtung 200 eingekoppelten Laserstrahls E bzw. Lichtstrahls dargestellt ist. Der Laserstrahl E ist durch das erste Substrat 210 hindurch in den in der Kavität 230 angeordneten Druckeinstellmaterialkörper 240 eingekoppelt gezeigt.

Anders ausgedrückt zeigt somit Fig. 3, dass der Laserstrahl E verwendet wird, um zum Einstellen eines Druck in der Kavität 230 den Druckeinstellmaterialkörper 240 zu aktivieren, beispielsweise aufzuheizen und/oder zu verdampfen. Hierzu ist zumindest eines der Substrate 210 und 220 für die verwendete Laserstrahlung transparent. Besonders vorteilhaft ist es, wenn eines der Substrate, hier das erste Substrat 210, transparent und das andere Substrat, hier das zweite Substrat 220, absorbierend für die verwendete Laserstrahlung gewählt sind. Hierdurch ist es möglich, direkt vor oder nach dem Druckeinstellprozess den Schichtstapel mittels Laserdurchstrahlschweißens zu fügen und so die mikrofluidische Vorrichtung 200 inklusive Druckeinstellung in einem Prozessschritt fertigzustellen bzw. herzustellen. Die Substrate 210 und 220 können gemäß einem Ausführungsbeispiel auch bereits untereinander, z. B. durch Kleben, Plasmabonden, Thermobonden oder Ultraschallschweißen, gefügt sein. Alternativ können die Substrate 210 und 220 während des Druckeinstellprozesses, d. h. während des Schrittes des Einkoppelns bei dem Verfahren zum Herstellen aus Fig. 1, z. B. durch zwei Stempel, mechanisch aufeinander gedrückt werden, wobei einer der Stempel für die verwendete Laserstrahlung transparent ist.

Durch Aufheizen des Druckeinstellmaterialkörpers 240 können nun unter Anderem folgende Effekte ausgenutzt werden: Wird der Druckeinstellmaterialkörper 240 über eine Siede- bzw. Zersetzungstemperatur erwärmt, treten Gase aus dem Druckeinstellmaterialkörper 240 aus und erhöhen den Druck innerhalb der Kavität 230. Insbesondere eine Masse des Druckeinstellmaterialkörpers 240 und eine Prozessführung bestimmen dabei eine Höhe des erzeugten Drucks. Je nach Material des Druckeinstellmaterialkörpers 240 ist außerdem eine Zusammensetzung des Gases einstellbar. Wird der Druckeinstellmaterialkörper 240 in Form eines Gettermaterials gewählt und mit Hilfe des Laserstrahls E verdampft, reagiert das gasförmige Gettermaterial mit den restlichen Gasmolekülen und kondensiert nach Abkühlung an Wänden der Kavität 230, wo durch das Gettermaterial weiterhin Gas absorbierbar ist. Hierdurch kann ein Unterdruck innerhalb der Kavität 230 erzeugt und gehalten werden. Wird der Druckeinstellmaterialkörper 240 in Form eines Gettermaterials gewählt und mit Hilfe des Laserstrahls E über seine Aktivierungstemperatur erwärmt, ohne zu verdampfen, werden Gasmoleküle an der Oberfläche des Gettermaterials adsorbiert. Hierdurch kann ein Unterdruck innerhalb der Kavität 230 erzeugt und gehalten werden.

Fig. 4 zeigt eine schematische Schnittdarstellung einer mikrofluidischen Vorrichtung 200 gemäß einem weiteren Ausführungsbeispiel der vorliegenden Erfindung. Dabei ist ein Druck in der mikrofluidischen Vorrichtung 200 durch Ausführen der dritten Ausführungsvariante des Verfahrens aus Fig. 1 eingestellt oder einstellbar. Gezeigt sind von der mikrofluidischen Vorrichtung 200 hierbei ein erstes Substrat 210, ein zweites Substrat 220, eine erste Kavität 230A, eine zweite Kavität 230B, ein erster Druckeinstellmaterialkörper 240A, ein zweiter Druckeinstellmaterialkörper 240B, ein mikrofluidischer Kanal 250 und ein Verbindungskanal 550. Die mikrofluidische Vorrichtung 200 sowie die Darstellung in Fig. 4 entsprechen der mikrofluidischen Vorrichtung sowie der Darstellung aus Fig. 2 mit der Ausnahme, dass in Fig. 4 die mikrofluidische Vorrichtung 200 zwei Kavitäten 230A und 230B sowie zwei Druckeinstellmaterialkörper 240A und 240B und zusätzlich der Verbindungskanal 550 aufweist.

Dabei ist der erste Druckeinstellmaterialkörper 240A in der ersten Kavität 230A angeordnet. Der erste Druckeinstellmaterialkörper 240A weist gemäß dem in Fig. 4 dargestellten Ausführungsbeispiel der vorliegenden Erfindung ein Gettermaterial auf. Der zweite Druckeinstellmaterialkörper 240B ist in der zweiten Kavität 230B angeordnet. Hierbei weist der zweite Druckeinstellmaterialkörper 240B gemäß dem in Fig. 4 dargestellten Ausführungsbeispiel der vorliegenden Erfindung ein Gasfreisetzungsmaterial auf. Die erste Kavität 230A und die zweite Kavität 230B sind mittels des Verbindungskanals 550 fluidisch miteinander verbunden. Der mikrofluidische Kanal 250 mündet hierbei in die zweite Kavität 230B.

Anders ausgedrückt sind in Fig. 4 die zwei Kavitäten 230A und 230B mit jeweils einem Druckeinstellmaterialkörper 240A und 240B über den Verbindungskanal 550 miteinander verbunden, wobei beispielsweise die zweite Kavität 230B über den mikrofluidischen Kanal 250 mit einem mikrofluidischen Netzwerk verbindbar ist. Der erste Druckeinstellmaterialkörper 240A umfasst gemäß dem in Fig. 4 dargestellten Ausführungsbeispiel der vorliegenden Erfindung ein Gettermaterial, während der zweite Druckeinstellmaterialkörper 240B ein Gasfreisetzungsmaterial bzw. ein Material zur Erzeugung eines Gases umfasst. Bei einem Herstellen der mikrofluidischen Vorrichtung 200 bzw. bei einem Einstellen eines Drucks in den Kavitäten 230A und 230B durch Ausführen der dritten Ausführungsvariante des Verfahrens aus Fig. 1 wird zunächst der erste Druckeinstellmaterialkörper 240A verdampft bzw. aktiviert, um Restgase aus den Kavitäten 230A und 230B zu entfernen. Nachfolgend wird der zweite Druckeinstellmaterialkörper 240B verdampft. Auf diese Weise kann eine besonders genaue Einstellung einer Gaszusammensetzung in den Kavitäten 230A und 230B erfolgen, da keine bzw. nur geringe Restgase vorhanden sind. Des Weiteren kann auf diese Weise in den Kavitäten 230A und 230B ein Unterdruck mit definierter Gaszusammensetzung gegenüber der Außenwelt hergestellt werden. Aufgrund der zwei Kavitäten 230A und 230B ergibt sich insbesondere ein Vorteil dahin gehend, dass ein durch Einkoppeln der Lichtenergie gasförmig gemachtes Gettermaterial aus dem ersten Druckeinstellmaterialkörper 240A vornehmlich in der ersten Kavität 230A kondensiert und damit ein im Wesentlichen optisch freier Zugang zum Einkoppeln von Lichtenergie auf den zweiten Druckeinstellmaterialkörper 240B erhalten bleibt.

Wird gemäß einem Ausführungsbeispiel für den ersten Druckeinstellmaterialkörper 240A ein Gettermaterial eingesetzt, das zum Aktivieren desselben nicht verdampft, sondern nur erwärmt zu werden braucht, kann anstelle der Kammern bzw. Kavitäten 230A und 230B auch lediglich eine Kavität vorgesehen sein, in der die beiden Druckeinstellmaterialkörper 240A und 240B angeordnet sind.

Es ist auch denkbar, zwei unterschiedliche Materialkörper zu verwenden, welche beide zur Gasfreisetzung oder beide zum Gettern eingesetzt werden, z. B. wenn eine Gaszusammensetzung nur durch das Verdampfen von zwei unterschiedlichen Stoffen möglich ist oder die Restgase Komponenten enthalten, die nur von zwei unterschiedlichen Gettermaterialien adsorbiert werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (100) zum Einstellen eines Druckes in einer mikrofluidischen Vorrichtung (200), wobei das Verfahren (100) folgende Schritte aufweist:
Bereitstellen (110) eines Schichtstapels, der ein erstes Substrat (210) und ein zweites Substrat (220) aufweist, wobei zwischen dem ersten Substrat (210) und dem zweiten Substrat (220) zumindest eine Kavität (230; 230A, 230B) angeordnet ist, in der zumindest ein Druckeinstellmaterialkörper (240; 240A, 240B) angeordnet ist, wobei zumindest das erste Substrat (210) für Lichtenergie (E) eines Wellenlängenbereichs transparent ausgeformt ist; und
Einkoppeln (120) von Lichtenergie (E) des Wellenlängenbereichs durch das erste Substrat (210) hindurch in den zumindest einen Druckeinstellmaterialkörper (240; 240A, 240B) innerhalb der zumindest einen Kavität (230; 230A, 230B), um ein Druckeinstellmaterial des zumindest einen Druckeinstellmaterialkörpers (240; 240A, 240B) zu aktivieren, um einen Druck in der zumindest einen Kavität (230; 230A, 230B) unter Verwendung des Druckeinstellmaterials physikochemisch einzustellen.

2. Verfahren (100) gemäß Anspruch 1, **dadurch gekennzeichnet, dass** im Schritt (110) des Bereitstellens ein Schichtstapel bereitgestellt wird, dessen zumindest einer Druckeinstellmaterialkörper (240; 240B) ein Gasfreisetzungsmaterial aufweist, wobei im Schritt (120) des Einkoppelns mittels der Lichtenergie (E) des Wellenlängenbereichs das Gasfreisetzungsmaterial zum Freisetzen von Gasmolekülen verdampfbar ist und/oder verdampft wird.

3. Verfahren (100) gemäß einem der vorangegangenen Ansprüche, **dadurch gekennzeichnet, dass** im Schritt (110) des Bereitstellens ein Schichtstapel bereitgestellt wird, dessen zumindest einer Druckeinstellmaterialkörper (240; 240A) ein Gettermaterial aufweist, wobei im Schritt (120) des Einkoppelns mittels der Lichtenergie (E) des Wellenlängenbereichs das Gettermaterial zum Einfangen und/oder Absorbieren von Gasmolekülen aktivierbar ist und/oder aktiviert wird.

4. Verfahren (100) gemäß einem der vorangegangenen Ansprüche, **dadurch gekennzeichnet, dass im** Schritt (110) des Bereitstellens ein Schichtstapel bereitgestellt wird, in dessen zumindest einer Kavität (230; 230A, 230B) ein erster Druckeinstellmaterialkörper (240; 240A) mit einem Gettermaterial und zumindest ein zweiter Druckeinstellmaterialkörper (240; 240B) mit einem Gasfreisetzungsmaterial angeordnet sind, wobei im Schritt (120) des Einkoppelns in einem ersten Teilschritt die Lichtenergie (E) des Wellenlängenbereichs in den ersten Druckeinstellmaterialkörper (240; 240A) eingekoppelt wird, um das Gettermaterial zu aktivieren, und in einem zweiten Teilschritt die Lichtenergie (E) des Wellenlängenbereichs in den zweiten Druckeinstellmaterialkörper (240; 240B) eingekoppelt wird, um das Gasfreisetzungsmaterial zu verdampfen.

5. Verfahren (100) gemäß einem der vorangegangenen Ansprüche, **dadurch gekennzeichnet, dass** im Schritt (110) des Bereitstellens der Schichtstapel in einem gefügten Zustand bereitgestellt wird, in dem das erste Substrat (210) und das zweite Substrat (220) stoffschlüssig miteinander verbunden sind.

6. Verfahren (100) gemäß einem der Ansprüche 1 bis 4, **dadurch gekennzeichnet, dass** im Schritt (110) des Bereitstellens der Schichtstapel in einem ungefügten Zustand bereitgestellt wird, in dem das erste Substrat (210) und das zweite Substrat (220) ungefügt aufeinander gestapelt sind, wobei das zweite Substrat (220) für die Lichtenergie (E) des Wellenlängenbereichs absorbierend ausgeführt ist, wobei im Schritt (120) des Einkoppelns die Lichtenergie (E) in den Schichtstapel eingekoppelt wird, um das erste Substrat (210) und das zweite Substrat (220) stoffschlüssig miteinander zu verbinden.

7. Mikrofluidische Vorrichtung (200), die einen Schichtstapel aufweist, der ein erstes Substrat (210) und ein zweites Substrat (220) aufweist, wobei zwischen dem ersten Substrat (210) und dem zweiten Substrat (220) zumindest eine Kavität (230; 230A, 230B) angeordnet ist, **dadurch gekennzeichnet, dass** in der zumindest einen Kavität (230; 230A, 230B) zumindest ein Druckeinstellmaterialkörper (240; 240A, 240B) angeordnet ist, wobei zumindest das erste Substrat (210) für Lichtenergie (E) eines Wellenlängenbereichs transparent ausgeformt ist, sodass Lichtenergie (E) des Wellenlängenbereichs durch das erste Substrat (210) hindurch in den zumindest einen Druckeinstellmaterialkörper (240; 240A, 240B) innerhalb der zumindest einen Kavität (230; 230A, 230B) einkoppelbar ist, um ein Druckeinstellmaterial des zumindest einen Druckeinstellmaterialkörpers (240; 240A, 240B) zu aktivieren, um einen Druck in der zumindest einen Kavität (230; 230A, 230B) unter Verwendung des Druckeinstellmaterials physikochemisch einzustellen.

8. Vorrichtung, die ausgebildet ist, um alle Schritte eines Verfahrens (100) gemäß einem der Ansprüche 1 bis 6 durchzuführen, umzusetzen und/oder anzusteuern.

9. Computerprogramm, das dazu eingerichtet ist, alle Schritte eines Verfahrens (100) gemäß einem der Ansprüche 1 bis 6 durchzuführen, umzusetzen und/oder anzusteuern.

10. Maschinenlesbares Speichermedium mit einem darauf gespeicherten Computerprogramm nach Anspruch 9.
